# EUROPÄISCHE PATENTANMELDUNG

(11) **EP 4 369 016 A1**
(43) Veröffentlichungstag der Anmeldung: **15.05.2024**
(21) Anmeldenummer: 22206365.3
(22) Anmeldetag: 09.11.2022
(51) Int. Cl.: G01R 33/28, G01R 33/36, G01R 33/54, G01R 33/561, G01R 33/58

(54) **VERFAHREN ZUR BERECHNUNG EINES BETRIEBSPARAMETERS EINER MAGNETRESONANZSEQUENZ, MAGNETRESONANZVORRICHTUNG UND COMPUTERPROGRAMMPRODUKT**

(71) Anmelder: Siemens Healthineers AG, 91301 Forchheim (DE)
(72) Erfinder: Grodzki, David, 91058 Erlangen (DE); Paul, Dominik, 91088 Bubenreuth (DE)
(74) Vertreter: Siemens Healthineers Patent Attorneys

(57) **Zusammenfassung**

Die Erfindung betrifft ein Verfahren zur Berechnung eines Betriebsparameters einer Magnetresonanzsequenz, eine Magnetresonanzvorrichtung und ein Computerprogrammprodukt. Gemäß dem Verfahren wird zumindest ein initialer Sequenzparameter eines HF-Sendepulses der Magnetresonanzsequenz bereitgestellt. Zudem wird zumindest ein Test-HF-Sendepuls ermittelt, insbesondere berechnet und/oder modelliert und/oder simuliert, wobei der zumindest eine Test-HF-Sendepuls anhand des zumindest einen initialen Sequenzparameters an eine vorgegebene, insbesondere geometrische, Standardform angepasst ist. Der zumindest eine Betriebsparameter wird mit Hilfe des zumindest einen Test-HF-Sendepulses ermittelt, insbesondere berechnet. Insbesondere wird dabei angenommen, dass der zumindest eine Test-HF-Sendepulse bei einer Durchführung der Magnetresonanzsequenz appliziert wird.

## Beschreibung

Die Erfindung betrifft ein Verfahren zur Berechnung eines Betriebsparameters einer Magnetresonanzsequenz, eine Magnetresonanzvorrichtung und ein Computerprogrammprodukt.

In der Medizintechnik zeichnet sich die Bildgebung mittels Magnetresonanz (MR), auch Magnetresonanztomographie (MRT, engl. Magnetic Resonance Imaging, MRI) genannt, durch hohe Weichteilkontraste aus. Hierbei werden während einer Magnetresonanzmessung mit Hilfe einer Magnetresonanzvorrichtung hochfrequente (HF, engl. radio-frequency, RF) Pulse zur Erzeugung eines HF-Feldes (auch B1-Feld genannt) und Gradientenpulse zur Erzeugung eines magnetischen Feldgradienten gemäß einer Magnetresonanzsequenz in einen Untersuchungsbereich eingestrahlt, in dem sich ein Patient befindet. Dadurch werden im Patienten ortskodierte Echosignale ausgelöst, die oftmals auch Magnetresonanzsignale genannt werden. Die Magnetresonanzsignale werden als Messdaten von der Magnetresonanzvorrichtung empfangen und zur Rekonstruktion von Magnetresonanzabbildungen verwendet.

Oftmals wird vor der Durchführung einer Magnetresonanzmessung kontrolliert, dass die Betriebsparameter der Magnetresonanzsequenz geeignet sind, gewisse Randbedingungen einzuhalten. Solche Randbedingungen können beispielsweise in der Leistungsfähigkeit der Magnetresonanzvorrichtung und/oder in der Patientensicherheit begründet sein. Diese Kontrolle kann mitunter sehr zeitaufwändig sein. Als Aufgabe der vorliegenden Erfindung kann insbesondere angesehen werden, die Berechnung von Betriebsparametern einer Magnetresonanzsequenz zu beschleunigen.

Die Aufgabe wird durch die Merkmale der unabhängigen Ansprüche gelöst. Vorteilhafte Ausgestaltungen sind in den abhängigen Ansprüchen beschrieben. Unabhängig vom grammatikalischen Geschlecht eines bestimmten Begriffes sind Personen mit männlicher, weiblicher oder anderer Geschlechteridentität mit umfasst.

Es wird ein computerimplementiertes Verfahren zur Berechnung zumindest eines Betriebsparameters einer Magnetresonanzsequenz vorgeschlagen. Dabei wird zumindest ein initialer Sequenzparameter eines HF-Sendepulses der Magnetresonanzsequenz bereitgestellt. Zudem wird zumindest ein Test-HF-Sendepuls ermittelt, insbesondere berechnet und/oder modelliert und/oder simuliert. Dabei ist der zumindest eine Test-HF-Sendepuls anhand des zumindest einen initialen Sequenzparameters an eine vorgegebene, insbesondere geometrische, Standardform angepasst. Der zumindest eine Betriebsparameter wird mit Hilfe des zumindest einen Test-HF-Sendepulses ermittelt, insbesondere berechnet.

Insbesondere wird bei der Ermittlung des zumindest einen Betriebsparameters angenommen, dass der zumindest eine Test-HF-Sendepulse bei einer Durchführung der Magnetresonanzsequenz appliziert wird. Insbesondere wird der zumindest eine Betriebsparameter für den Fall ermittelt, dass als HF-Sendepuls der zumindest eine Test-HF-Sendepuls verwendet wird. Beispielsweise wird dadurch überprüft, welchen Wert der zumindest eine Betriebsparameter annimmt, wenn als HF-Sendepuls der zumindest eine Test-HF-Sendepuls verwendet wird.

Die Magnetresonanzsequenz kann insbesondere zumindest ein Sequenzmodul umfassen. Ein Sequenzmodul kann beispielsweise ein HF-Sendepuls oder ein Gradientenpuls sein. Vorzugsweise umfasst die Magnetresonanzsequenz mehrere Sequenzmodule, die im zeitlichen Verlauf der Magnetresonanzmessung appliziert werden. Die Sequenzmodule können zeitlich nacheinander und/oder zumindest teilweise gleichzeitig (insbesondere zeitlich überlappend) appliziert werden. Der zumindest eine initiale Sequenzparameter und/oder der zumindest eine angepasste Sequenzparameter kann beispielsweise eine Eigenschaft des zumindest einen Sequenzmoduls sein.

Vorteilhafterweise kann durch die Verwendung der vorgegebenen Standardform das Ermitteln des zumindest einen Betriebsparameters vereinfacht werden. Vorteilhafterweise können die dazu notwendigen Rechenoperationen reduziert werden. Vorteilhafterweise weist die vorgegebene Standardform eine geringere Komplexität auf als eine tatsächliche Form eines typischen HF-Sendepulses. Vorteilhafterweise stellt die vorgegebene Standardform eine Annäherung an eine tatsächliche Form eines typischen HF-Sendepulses dar.

Vorzugsweise weist der zumindest eines Test-HF-Sendepuls die vorgegebene Standardform auf, die durch den zumindest einen initialen Sequenzparameter festgelegt ist. Der zumindest eine Test-HF-Sendepuls kann vorzugsweise durch eine, insbesondere mathematische, Modellfunktion beschrieben werden, die der vorgegebenen Standardform entspricht.

Vorzugsweise ist die Standardform dadurch gekennzeichnet, dass sie eine Amplitude und/oder Fläche beschreibt, die jeweils mindestens so groß sind wie eine Amplitude und/oder Fläche eines etwaigen zu ermittelnden Mess-HF-Sendepulses.

Beispielsweise kann die vorgegebene Standardform eine Rechteckform sein. Der zumindest eine Test-HF-Sendepuls kann dann durch eine Rechteckfunktion als Modellfunktion beschrieben werden. Vorteilhafterweise ist eine Rechteckform besonders geeignet, um einen HF-Sendepuls, insbesondere einen etwaigen zu ermittelnden Mess-HF-Sendepuls, vereinfachend anzunähern.

Vorteilhafterweise eignet sich eine Rechteckform besonders gut zur Annäherung an einen dynamischen Puls. Für mögliche andere Pulstypen können sich auch andere Formen gut eignen, um dem erwarteten HF-Sendepuls nahe zu kommen.

Der zumindest eine Betriebsparameter kann insbesondere einen Zustand der Magnetresonanzvorrichtung und/oder des Patienten während einer Magnetresonanzmessung beschreiben. Insbesondere ist der zumindest eine Betriebsparameter von der Ausprägung des zumindest einen Sequenzmoduls der Magnetresonanzsequenz, anhand derer die Magnetresonanzmessung durchgeführt wird.

Vorzugsweise umfasst der zumindest eine initiale Sequenzparameter eine, insbesondere maximale, (initiale) Pulsdauer des zumindest einen HF-Sendepulses, die einer, insbesondere maximalen, Breite der Rechteckform entspricht. Vorzugsweise umfasst der zumindest eine initiale Sequenzparameter eine, insbesondere maximale, (initiale) Amplitude des zumindest einen HF-Sendepulses, die einer, insbesondere maximalen, Höhe der Rechteckform entspricht. Ein langandauernder HF-Sendepuls wird also beispielsweise durch ein Rechteck mit einer großen Breite modelliert; ein starker wird also beispielsweise durch ein Rechteck mit einer großen Höhe modelliert.

Beispielsweise ist die (initiale) Pulsdauer für eine durchzuführende Magnetresonanzsequenz vorgegeben. Die Vorgabe der (initialen) Pulsdauer kann insbesondere spezifisch für den Typ der Magnetresonanzsequenz sein. Die Vorgabe der (initialen) Pulsdauer kann aber auch individuell für eine spezifische Magnetresonanzmessung, beispielsweise durch ein Bedienpersonal der Magnetresonanzvorrichtung, eingestellt werden.

Beispielsweise umfasst der zumindest eine Betriebsparameter eine Leistungsanforderung an die Magnetresonanzvorrichtung, insbesondere an einen Hochfrequenzverstärker der Magnetresonanzvorrichtung, mit der die Magnetresonanzsequenz auszuführen ist. Eine Leistungsanforderung an einen Hochfrequenzverstärker der Magnetresonanzvorrichtung kann beispielsweise eine Anforderung an eine elektrische Wiederaufladefähigkeit des Hochfrequenzverstärkers und/oder eine maximale elektrische Aufladekapazität des Hochfrequenzverstärkers sein.

Die Wiederaufladefähigkeit kann insbesondere durch eine Rate beschrieben werden, mit der eine elektrische Wiederaufladung des Hochfrequenzverstärkers erfolgt. Diese kann beispielsweise in der Einheit Coulomb/Sekunden ausgedrückt werden. Die maximale elektrische Aufladekapazität kann insbesondere durch die maximale elektrische Ladung beschrieben werden, die (temporär) gespeichert und zum Senden von Sendepulsen abgebaut werden kann. Diese kann beispielsweise in der Einheit Coulomb ausgedrückt werden.

Der zumindest eine Betriebsparameter kann insbesondere eine spezifische Absorptionsrate umfassen, die bei Ausführung der Magnetresonanzsequenz auf einen Patienten einwirkt.

Die spezifische Absorptionsrate kann insbesondere die pro Zeiteinheit und pro Kilogramm Körpergewicht absorbierte hochfrequente Energie nach HF-Einstrahlung sein. Die Absorption der HF-Energie kann zur Erwärmung des Körpergewebes des Patienten führen. Bei unzulässig hoher lokaler Konzentration von HF-Energie können HF-Verbrennungen auftreten (lokale SAR). Bei gleichmäßiger Verteilung der HF-Energie über den ganzen Körper ist die Belastung der Thermoregulation bzw. des Herzkreislaufsystems des Patienten maßgeblich (Ganzkörper-SAR). Die zumindest eine Randbedingung kann beispielsweise ein Kurzzeit-SAR-Limit, insbesondere ein 10s-SAR-Limit, umfassen.

Vorzugsweise wird ferner zumindest eine Randbedingung an den zumindest einen Betriebsparameter bereitgestellt und zumindest ein angepasster Sequenzparameter durch Anpassung des zumindest einen initialen Sequenzparameters ermittelt, so dass die bereitgestellte zumindest eine Randbedingung eingehalten wird.

Beispielsweise wird als zumindest eine Randbedingung ein SAR-Grenzwert und/oder eine Leistungsgrenze der Magnetresonanzvorrichtung, insbesondere eines Hochfrequenzverstärkers der Magnetresonanzvorrichtung, bereitgestellt. Vorteilhafterweise kann dadurch die Patientensicherheit und/oder die Betriebssicherheit der Magnetresonanzvorrichtung, insbesondere ein Schutz von Komponenten der Magnetresonanzvorrichtung, erhöht werden.

Das Ermitteln des zumindest einen angepassten Sequenzparameters kann insbesondere mittels eines iterativen Verfahrens durchgeführt werden. Beispielsweise kann anhand des zumindest einen initialen Sequenzparameters zumindest ein erster Sequenzparameter ermittelt werden, woraufhin geprüft wird, ob die bereitgestellte zumindest eine Randbedingung bei Anwendung des zumindest einen ersten Sequenzparameters eingehalten wird. Falls die zumindest eine Randbedingung eingehalten wird, ist der zumindest eine erste Sequenzparameter der zumindest eine angepasste Sequenzparameter. Falls die zumindest eine Randbedingung eingehalten wird, wird zumindest ein zweiter Sequenzparameter ermittelt, anhand dessen eine weitere Prüfung erfolgt usw.

Gemäß einer weiteren Ausführungsform umfasst das Verfahren ferner ein Ermitteln zumindest eines Mess-HF-Sendepulses anhand des zumindest einen angepassten Sequenzparameters. Beispielsweise repräsentiert der zumindest eine angepasste Sequenzparameter zumindest eine Randbedingung und/oder Anforderung und/oder Einschränkung für das Ermitteln des zumindest einen Mess-HF-Sendepulses.

Insbesondere kann eine Magnetresonanzmessung gemäß einer Magnetresonanzsequenz durchgeführt werden, wobei die Magnetresonanzsequenz den zumindest einen Mess-HF-Sendepuls umfasst. Vorteilhafterweise können durch die Magnetresonanzmessung Magnetresonanzsignale empfangen werden, wobei aus den Magnetresonanzsignale zumindest eine Magnetresonanzabbildung erzeugt wird.

Vorzugsweise ist der zumindest eine Mess-HF-Sendepuls ein dynamischer Puls, insbesondere ein pTx-Puls.

Als dynamischer Puls kann insbesondere ein HF-Sendepuls angesehen werden, dessen Phase und/oder Amplitude sich im zeitlichen Verlauf des Pulses ändert, während mittels einer Gradientenspuleneinheit der Magnetresonanzvorrichtung eine, insbesondere vorbestimmte, Gradiententrajektorie abgetastet wird. Insbesondere erfolgt die Abtastung der Gradiententrajektorie zeitlich mit der Variation von Phase und/oder Amplitude des HF-Sendepulses.

Es ist auch denkbar, die Gesamtheit aus HF-Sendepuls und Gradiententrajektorie als dynamischen Puls zu betrachten. Dann wäre der HF-Sendepuls ein Teil des dynamischen Pulses.

"pTx" steht hierbei für "paralleles Senden", engl. "parallel transmission". Ein pTx-Puls kann mehrere Teilpulse umfassen, die parallel, insbesondere gleichzeitig, durch jeweils eine Sendeantenne einer Hochfrequenzantenneneinheit der Magnetresonanzvorrichtung gesendet werden. Jeder Sendeantenne kann wiederum ein Sendekanal zugeordnet werden. Dabei können sich die Teilpulse insbesondere in ihrer Form und/oder Amplitude und/oder Phase unterscheiden. Ferner können die Teilpulse eine zeitliche Verzögerung zueinander aufweisen. Beispielsweise setzt sich ein emittierbarer HF-Sendepuls aus mehreren Teilpulsen zusammen, die voneinander abweichen und jeweils durch eine Sendeantenne einer mehrkanaligen Sendeantennenanordnung der Hochfrequenzantenneneinheit gesendet werden können. Vorzugsweise sind zumindest ein Teil der mehreren Teilpulse, insbesondere alle Teilpulse, dynamische Pulse.

Durch einen dynamischen Puls kann vorteilhafterweise das dadurch erzeugte B1-Feld präziser kontrolliert werden; eine solche Kontrolle kann insbesondere bei Anwendungen mit reduziertem Sichtfeld, geformten Sättigungsbändern oder zur Reduktion der spezifischen Absorptionsrate vorteilhaft sein. Insbesondere können mit einem pTx-Puls Magnetfeldinhomogenitäten ausgeglichen werden (beispielsweise im Rahmen eines "HF-Shimming"), das vor allem bei höheren Feldstärken des Hauptmagnetfelds ab 7 Tesla besonders vorteilhaft sein kann.

Bei einem Senden eines dynamischen Pulses, insbesondere eines pTx-Pulses, lässt sich vorteilhafterweise eine vorbestimmte räumliche Verteilung der Anregung als zusätzlicher Freiheitsgrad durch Interferenz der Signale der Mehrzahl an Sendekanälen über eine Mehrzahl an Sendeantennen der Hochfrequenzantenneneinheit erzielen, die beim Bestimmen des dynamischen Pulses beispielsweise durch Variation von Phase und Amplitude eingestellt wird.

Die zumindest eine Form und/oder Amplitude und/oder Phase des HF-Sendepulses bzw. eines Teilpulses kann beispielsweise einer Form und/oder Amplitude und/oder Phase eines Spannungspulses, der an die jeweilige Sendeantenne angelegt wird, und/oder eines Strompulses, der durch die Sendeantenne fließt, entsprechen.

Die zumindest eine Form und/oder Amplitude und/oder Phase des Gradientenpulses kann beispielsweise einer Form und/oder Amplitude und/oder Phase eines Spannungspulses, der an die Gradientenspuleneinheit angelegt wird, und/oder eines Strompulses, der durch die Gradientenspuleneinheit fließt, entsprechen.

Vorzugsweise umfasst der zumindest eine angepasste Sequenzparameter zumindest eine Randbedingung zur Ermittlung des zumindest einen Mess-HF-Sendepulses. Vorzugsweise umfasst der zumindest eine angepasste Sequenzparameter (als zumindest eine Randbedingung) eine maximale Pulsdauer und/oder eine maximale Amplitude zur Ermittlung des zumindest einen Mess-HF-Sendepulses. Insbesondere gibt der zumindest eine angepasste Sequenzparameter einen maximale Pulsdauer und/oder eine maximale Amplitude zur Ermittlung des zumindest einen Mess-HF-Sendepulses vor, d.h. die Breite des zumindest einen Mess-HF-Sendepulses darf maximal die maximale Pulsdauer betragen, und/oder die Amplitude des zumindest einen Mess-HF-Sendepulses darf maximal die maximale Amplitude betragen.

Insbesondere dann, wenn der zumindest eine Test-HF-Sendepuls durch einen Rechteckpuls angenähert wird, wird der (tatsächliche) zumindest eine Mess-HF-Sendepuls zwar üblicherweise "überschätzt", jedoch vorteilhafterweise nur in einem so geringen Maße, dass damit möglicherweise verbundene Performance-Verluste problemlos hinnehmbar sind. Andererseits ist der Zeitgewinn beim Ermitteln des zumindest einen Betriebsparameters oftmals beträchtlich.

Ferner wird eine Magnetresonanzvorrichtung vorgeschlagen, die ausgebildet ist, ein vorab beschriebenes Verfahren zur Berechnung zumindest eines Betriebsparameters einer Magnetresonanzsequenz durchzuführen. Die Magnetresonanzvorrichtung umfasst dazu vorzugsweise eine Recheneinheit mit einem oder mehreren Prozessoren und/oder Speichermodulen. Die Recheneinheit kann beispielsweise als Teil einer Systemsteuereinheit der Magnetresonanzvorrichtung ausgebildet sein.

Die Vorteile der vorgeschlagenen Magnetresonanzvorrichtung entsprechen im Wesentlichen den Vorteilen des vorgeschlagenen Verfahrens zur Berechnung zumindest eines Betriebsparameters einer Magnetresonanzsequenz, welche vorab im Detail ausgeführt sind. Hierbei erwähnte Merkmale, Vorteile oder alternative Ausführungsformen können ebenso auch auf die anderen beanspruchten Gegenstände übertragen werden und umgekehrt.

Ferner wird ein Computerprogrammprodukt vorgeschlagen, das ein Programm umfasst und direkt in einen Speicher einer programmierbaren Systemsteuereinheit einer Magnetresonanzvorrichtung ladbar ist und Programmmittel, z.B. Bibliotheken und Hilfsfunktionen, aufweist, um ein vorab vorgeschlagenes Verfahren auszuführen, wenn das Computerprogrammprodukt in der Systemsteuereinheit der Magnetresonanzvorrichtung ausgeführt wird. Das Computerprogrammprodukt kann dabei eine Software mit einen Quellcode, der noch kompiliert und gebunden oder der nur interpretiert werden muss, oder einen ausführbaren Softwarecode umfassen, der zur Ausführung nur noch in die Systemsteuereinheit zu laden ist.

Durch das Computerprogrammprodukt kann das vorgeschlagene Verfahren vorteilhafterweise schnell, identisch wiederholbar und robust ausgeführt werden. Das Computerprogrammprodukt ist vorzugsweise so konfiguriert, dass es mittels der Systemsteuereinheit die vorgeschlagenen Verfahrensschritte ausführen kann. Die Systemsteuereinheit weist dabei jeweils die Voraussetzungen wie beispielsweise einen entsprechenden Arbeitsspeicher, eine entsprechende Grafikkarte oder eine entsprechende Logikeinheit auf, so dass die jeweiligen Verfahrensschritte effizient ausgeführt werden können.

Das Computerprogrammprodukt ist beispielsweise auf einem computerlesbaren Medium gespeichert oder auf einem Netzwerk oder Server hinterlegt, von wo es in den Prozessor einer lokalen Systemsteuereinheit geladen werden kann, der mit der Magnetresonanzvorrichtung direkt verbunden oder als Teil der Magnetresonanzvorrichtung ausgebildet sein kann. Weiterhin können Steuerinformationen des Computerprogrammprodukts auf einem elektronisch lesbaren Datenträger gespeichert sein. Die Steuerinformationen des elektronisch lesbaren Datenträgers können derart ausgestaltet sein, dass sie bei Verwendung des Datenträgers in einer Systemsteuereinheit einer Magnetresonanzvorrichtung ein vorgeschlagenes Verfahren durchführen.

Beispiele für elektronische lesbare Datenträger sind eine DVD, ein Magnetband oder einen USB-Stick, auf welchem elektronisch lesbare Steuerinformationen, insbesondere Software, gespeichert ist. Wenn diese Steuerinformationen von dem Datenträger gelesen und in eine Systemsteuereinheit der Magnetresonanzvorrichtung gespeichert werden, können alle vorgeschlagenen Ausführungsformen der vorab beschriebenen Verfahren durchgeführt werden.

Weitere Vorteile, Merkmale und Einzelheiten der Erfindung ergeben sich aus den im Folgenden beschriebenen Ausführungsbeispielen sowie anhand der Zeichnungen. Einander entsprechende Teile sind in allen Figuren mit den gleichen Bezugszeichen versehen.

Es zeigen:
- Fig. 1: eine Magnetresonanzvorrichtung in einer schematischen Darstellung,
- Fig. 2: ein Blockdiagramm eines vorgeschlagenen Verfahrens,
- Fig. 3: rechteckförmige Test-HF-Sendepulse und ein Mess-HFSendepuls.

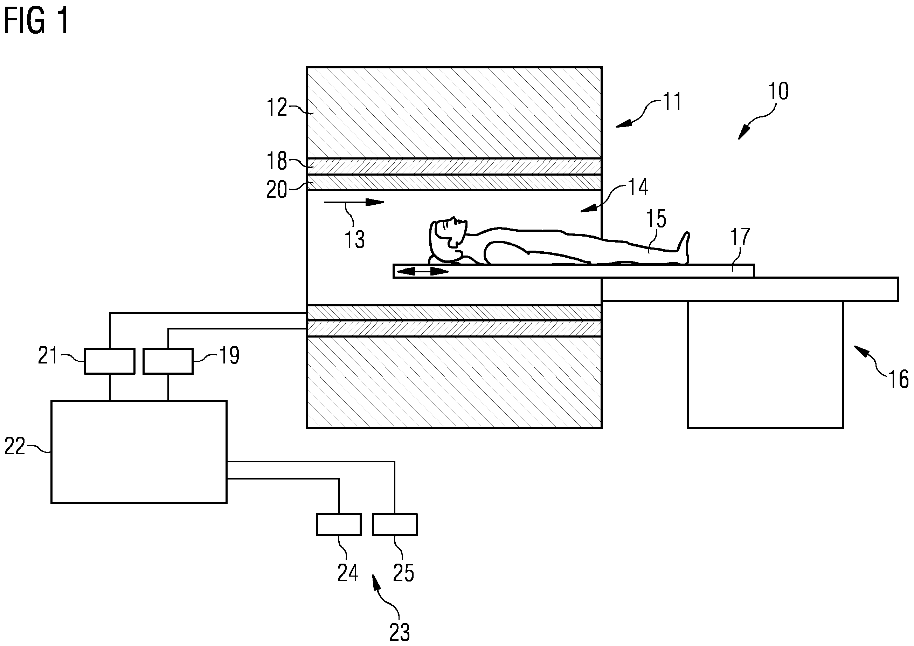

In Fig. 1 ist eine Magnetresonanzvorrichtung 10 schematisch dargestellt. Die Magnetresonanzvorrichtung 10 umfasst eine Magneteinheit 11, die einen Hauptmagneten 12 zu einem Erzeugen eines starken und insbesondere zeitlich konstanten Hauptmagnetfelds 13 aufweist. Zudem umfasst die Magnetresonanzvorrichtung 10 einen Patientenaufnahmebereich 14 zu einer Aufnahme eines Patienten 15. Der Patientenaufnahmebereich 14 im vorliegenden Ausführungsbeispiel ist zylinderförmig ausgebildet und in einer Umfangsrichtung von der Magneteinheit 11 zylinderförmig umgeben. Grundsätzlich ist jedoch eine davon abweichende Ausbildung des Patientenaufnahmebereichs 14 jederzeit denkbar. Der Patient 15 kann mittels einer Patientenlagerungsvorrichtung 16 der Magnetresonanzvorrichtung 10 in den Patientenaufnahmebereich 14 geschoben werden. Die Patientenlagerungsvorrichtung 16 weist hierzu einen innerhalb des Patientenaufnahmebereichs 14 bewegbar ausgestalteten Patiententisch 17 auf.

Die Magneteinheit 11 weist weiterhin eine Gradientenspuleneinheit 18 zu einer Erzeugung von Magnetfeldgradienten auf, die für eine Ortskodierung während einer Bildgebung verwendet werden. Die Gradientenspuleneinheit 18 wird mittels einer Gradientensteuereinheit 19 der Magnetresonanzvorrichtung 10 gesteuert. Die Magneteinheit 11 umfasst weiterhin eine Hochfrequenzantenneneinheit 20, welche im vorliegenden Ausführungsbeispiel als fest in die Magnetresonanzvorrichtung 10 integrierte Körperspule ausgebildet ist. Die Hochfrequenzantenneneinheit 20 wird von einer Hochfrequenzantennensteuereinheit 21 der Magnetresonanzvorrichtung 10 gesteuert und strahlt HF-Sendepulse, insbesondere zumindest einen Test-HF-Sendepuls und/oder Mess-HF-Sendepuls, in einen Untersuchungsraum ein, der im Wesentlichen von einem Patientenaufnahmebereich 14 der Magnetresonanzvorrichtung 10 gebildet ist. Dadurch stellt sich dem von dem Hauptmagneten 12 erzeugten Hauptmagnetfeld 13 eine Anregung von Atomkernen ein. Durch Relaxation der angeregten Atomkerne werden Magnetresonanzsignale erzeugt. Die Hochfrequenzantenneneinheit 20 ist zum Empfang der Magnetresonanzsignale ausgebildet.

Um geeignete elektrische Signale an die Hochfrequenzantenneneinheit 20 zu übertragen, umfasst die Hochfrequenzantennensteuereinheit 21 einen oder mehrere (hier nicht dargestellte) Hochfrequenzverstärker, die ein Steuersignal der Systemsteuereinheit 22 zu einem Leistungssignal verstärken können. Der Hochfrequenzverstärker ist ausgebildet, eine elektrische Ladung, insbesondere Vorladung, temporär zu speichern, die er dann bei Verstärkung eines Sendepulses abbaut. So ist der Hochfrequenzverstärker in der Lage, Sendepulse mit hoher Flankensteilheit zu verstärken. Zum Speichern der elektrischen Ladung umfasst der Hochfrequenzverstärker vorzugsweise zumindest einen Kondensator.

Die Hochfrequenzantenneneinheit 20 kann mehrere Sendeantennen umfassen. Insbesondere kann die Hochfrequenzantenneneinheit 20 zum Erzeugen, insbesondere Senden, von dynamischen Pulsen ausgebildet sein. Hochfrequenzantenneneinheit 20 kann zusätzlich oder alternativ eine (hier nicht dargestellte) Sende-Lokalspule mit einer oder mehreren Sendeantennen umfassen, die unmittelbar am Patienten 15 angeordnet werden kann. Dies ist vor allem vorteilhaft bei Magnetresonanzvorrichtungen 10 mit starkem Hauptmagnetfeld 13, z.B. 7 Tesla oder mehr.

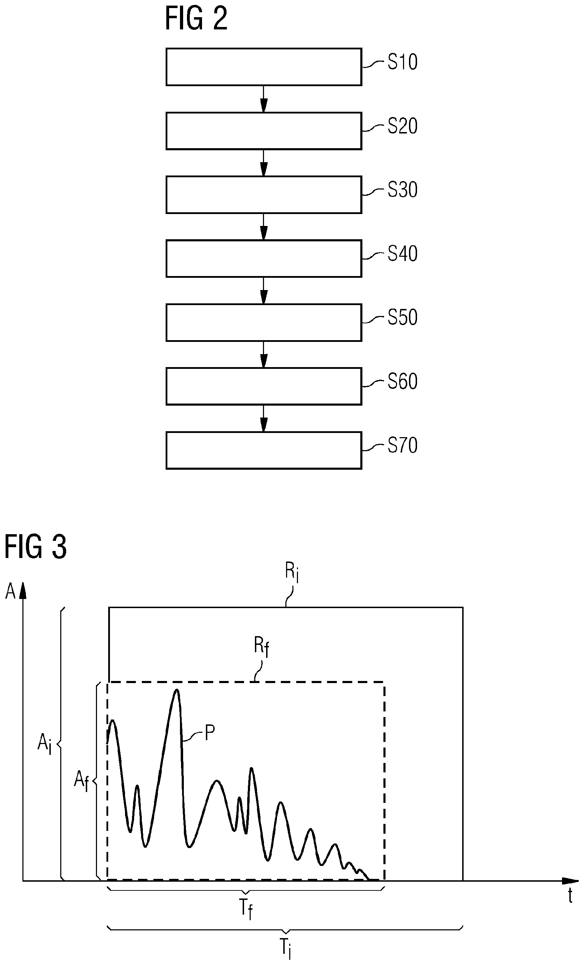

Zu einer Steuerung des Hauptmagneten 12, der Gradientensteuereinheit 19 und zur Steuerung der Hochfrequenzantennensteuereinheit 21 weist die Magnetresonanzvorrichtung 10 eine Systemsteuereinheit 22 auf. Die Systemsteuereinheit 22 steuert zentral die Magnetresonanzvorrichtung 10, wie beispielsweise das Durchführen einer Magnetresonanzsequenz. Vorzugsweise ist die Systemsteuereinheit 22 ausgebildet, zumindest einen Betriebsparameter der Magnetresonanzsequenz gemäß dem Verfahren gemäß Fig. 2 zu berechnen. Zudem umfasst die Systemsteuereinheit 22 eine nicht näher dargestellte Auswerteeinheit zu einer Auswertung der Magnetresonanzsignale, die während der Magnetresonanzuntersuchung erfasst werden. Des Weiteren umfasst die Magnetresonanzvorrichtung 10 eine Benutzerschnittstelle 23, die mit der Systemsteuereinheit 22 verbunden ist. Steuerinformationen wie beispielsweise Bildgebungsparameter, sowie rekonstruierte Magnetresonanzabbildungen können auf einer Anzeigeeinheit 24, beispielsweise auf zumindest einem Monitor, der Benutzerschnittstelle 23 für ein medizinisches Bedienpersonal angezeigt werden. Weiterhin weist die Benutzerschnittstelle 23 eine Eingabeeinheit 25 auf, mittels der Informationen und/oder Parameter während eines Messvorgangs von dem medizinischen Bedienpersonal eingegeben werden können.

Gemäß dem in Fig. 2 dargestellten Verfahren wird in S10 zumindest eine initialer Sequenzparameter eines HF-Sendepulses einer Magnetresonanzsequenz bereitgestellt. Die Bereitstellung kann beispielsweise durch Laden des zumindest einen initialen Sequenzparameters aus einer Datenbank und/oder durch Eingabe des zumindest einen initialen Sequenzparameters durch das Bedienpersonal mittels der Benutzerschnittstelle 23 erfolgen. Beispielsweise aus der Datenbank eine Magnetresonanzsequenz geladen werden, für die der zumindest eine Sequenzparameter, beispielsweise eine Pulsdauer, vorgegeben ist. Vorzugsweise läuft die Übernahme des zumindest einen Sequenzparameter, beispielsweise der Pulsdauer, automatisch im Hintergrund ab und/oder ist für das Bedienpersonal nicht oder nur indirekt sichtbar.

Ferner kann die Bereitstellung des zumindest einen initialen Sequenzparameter des HF-Sendepulses eine Bereitstellung einer, insbesondere maximalen, Amplitude des HF-Sendepulses umfassen. Diese wird beispielsweise wird aus einer maximal durch die Magnetresonanzvorrichtung erzeugbaren Amplitude und/oder aus einer Referenzspannung des Patienten 15 ermittelt, welche Referenzspannung in zumindest einer möglichen Vorab-Messung bestimmt wird. Vorzugsweise erfolgt die Bereitstellung der Amplitude auch automatisch und/oder nicht oder nur indirekt sichtbar für das Bedienpersonal.

In S20 wird zumindest ein Test-HF-Sendepuls erzeugt, wobei der zumindest eine Test-HF-Sendepuls anhand des zumindest einen initialen Sequenzparameters an eine vorgegebene Standardform angepasst ist.

Die Standardform kann beispielsweise eine Rechteckform sein. Dabei kann der zumindest eine in S10 bereitgestellte initiale Sequenzparameter eine, insbesondere maximale, Pulsdauer umfassen, die einer, insbesondere maximalen, Breite der Rechteckform entspricht. Ferner kann der zumindest eine initiale Sequenzparameter eine, insbesondere maximale, Amplitude umfassen, die einer, insbesondere maximalen, Höhe der Rechteckform entspricht.

In S30 wird zumindest ein Betriebsparameter mit Hilfe des zumindest einen Test-HF-Sendepulses ermittelt. Der zumindest eine Betriebsparameter kann eine Leistungsanforderung an die Magnetresonanzvorrichtung 10, insbesondere an einen Hochfrequenzverstärker der Magnetresonanzvorrichtung 10, umfassen, die bei Ausführung der Magnetresonanzsequenz von der Magnetresonanzvorrichtung, insbesondere von dem Hochfrequenzverstärker, zu erfüllen ist. Ferner kann der zumindest eine Betriebsparameter eine spezifische Absorptionsrate umfassen, die bei Ausführung der Magnetresonanzsequenz auf einen Patienten 15 einwirkt.

In S40 wird zumindest eine Randbedingung, z.B. ein Leistungslimit des Hochfrequenzverstärkers und/oder ein SAR-Grenzwert, an den zumindest einen Betriebsparameter bereitgestellt. (S40 kann auch vor S10, S20 oder S30 und/oder gleichzeitig mit S10, S20 oder S30 erfolgen.)

In S50 wird zumindest ein angepasster Sequenzparameter durch Anpassung des zumindest einen initialen Sequenzparameters ermittelt, so dass die bereitgestellte zumindest eine Randbedingung eingehalten wird.

In S60 zumindest ein Mess-HF-Sendepulses, z.B. ein dynamischer Puls, anhand des zumindest einen angepassten Sequenzparameters ermittelt.

In S70 wird eine Magnetresonanzmessung gemäß einer Magnetresonanzsequenz durchgeführt, wobei die Magnetresonanzsequenz den zumindest einen Mess-HF-Sendepuls umfasst, so dass der zumindest einen Mess-HF-Sendepuls während der Magnetresonanzmessung zumindest einmal appliziert wird. Vorteilhafterweise können durch die Magnetresonanzmessung Magnetresonanzsignale empfangen werden, wobei aus den Magnetresonanzsignale zumindest eine Magnetresonanzabbildung erzeugt, insbesondere rekonstruiert, wird.

Das vorgeschlagene Verfahren eignet sich besonders gut zur Ermittlung von dynamischen Pulsen. Dies wird anhand von Fig. 3 näher verdeutlicht. Darin ist ein initialer Rechteckpuls Rᵢ als in S20 ermittelter Test-HF-Sendepuls dargestellt. Dessen Breite entspricht einer initialen Pulsdauer Tᵢ als ein erster initialer Sequenzparameter, und dessen Höhe entspricht einer initialen Amplitude Aᵢ als ein zweiter initialer Sequenzparameter, welche initialen Sequenzparameter jeweils in S10 bereitgestellt werden.

Basierend auf dem initialen Rechteckpuls Rᵢ wird der zumindest eine Betriebsparameter in S30 ermittelt. Insbesondere wird die Situation simuliert, dass die Hochfrequenzantenneneinheit 20 den Rechteckpuls Rᵢ als HF-Sendepuls aussendet, um den daraus resultierenden zumindest einen Betriebsparameter zu ermitteln. Dieser zumindest eine Betriebsparameter kann dann mit der in S40 bereitgestellten zumindest einen Randbedingung verglichen werden. Wird die zumindest eine Randbedingung eingehalten, kann der zumindest eine initiale Sequenzparameter, also beispielsweise die initialen Pulsdauer Tᵢ und/oder die initiale Amplitude Aᵢ, zur Ermittlung des zumindest einen Mess-HF-Sendepulses unverändert verwendet werden.

Wird die zumindest einen Randbedingung jedoch nicht eingehalten, so wird in S50 zumindest ein angepasster Sequenzparameter ermittelt, so dass die bereitgestellte zumindest eine Randbedingung eingehalten wird. Beispielsweise wird die Amplitude auf den Wert A_{f} angepasst und die Pulsdauer auf den Wert T_{f}. Diese Anpassung kann insbesondere iterativ erfolgen, d.h. es kann wiederholt eine Veränderung der Sequenzparameter mit anschließender Überprüfung der zumindest einen Randbedingung durchgeführt werden, bis die zumindest einen Randbedingung eingehalten wird.

Wird nun die zumindest einen Randbedingung bei Anwendung eines Rechteckpulses mit den Werten T_{f} (für die Pulsdauer) und A_{f} (für die Amplitude) eingehalten, dann können diese Werte als angepasste Sequenzparameter als Randbedingungen, insbesondere als maximale Pulsdauer und maximale Amplitude, zur Ermittlung des zumindest einen Mess-HF-Sendepulses in S60 verwendet werden. So kann dann beispielsweise ein dynamischer Puls P ermittelt werden, der kürzer als die maximale Pulsdauer und niedriger als die maximale Amplitude ist.

Es wird also insbesondere vorgeschlagen, den dynamischen Puls P in den Berechnungen mit einem Rechteckpuls anzunähern, der beispielsweise die gleiche Länge wie der resultierende dynamische Puls und eine Amplitude, die der Maximalamplitude des dynamischen Pulses entspricht, besitzt, und nur im letzten Test-Schritt nach Finden einer ausführbaren Lösung den tatsächlichen dynamischen Puls zu berechnen.

Dies ist deshalb vorteilhaft möglich, weil dynamische Pulse üblicherweise über den Pulsverlauf eine sehr hohe und nahezu konstante Amplitude aufweisen. Durch Annähern dieses Pulses mit einem Rechteckpuls, wird der tatsächliche Puls zwar "überschätzt", jedoch nur in einem geringen Umfang.

Insbesondere wird vorgeschlagen, dynamische Pulse für Berechnungen einer Leistungsanforderung an einen Hochfrequenzverstärker und/oder einer SAR durch einen Rechteckpuls anzunähern und erst nach diesen Berechnungen bzw. im letzten Test-Schritt den dynamischen Puls mit den geforderten Randbedingungen zu berechnen. Auf diese Weise kann verhindert werden, dass eine zeitaufwändige Neuberechnung der dynamischen Pulse bei den, insbesondere iterativen, Berechnungsschritten solcher Berechnungen immer wieder aufs Neue gestartet wird.

Es wird abschließend noch einmal darauf hingewiesen, dass es sich bei den vorhergehend detailliert beschriebenen Verfahren sowie bei der dargestellten Magnetresonanzvorrichtung lediglich um Ausführungsbeispiele handelt, welche vom Fachmann in verschiedenster Weise modifiziert werden können, ohne den Bereich der Erfindung zu verlassen. Weiterhin schließt die Verwendung der unbestimmten Artikel "ein" bzw. "eine" nicht aus, dass die betreffenden Merkmale auch mehrfach vorhanden sein können. Ebenso schließt der Begriff "Einheit" nicht aus, dass die betreffenden Komponenten aus mehreren zusammenwirkenden Teil-Komponenten bestehen, die gegebenenfalls auch räumlich verteilt sein können.

## Patentansprüche

1. Computerimplementiertes Verfahren zur Berechnung zumindest eines Betriebsparameters einer Magnetresonanzsequenz, umfassend:
Bereitstellen zumindest eines initialen Sequenzparameters eines HF-Sendepulses der Magnetresonanzsequenz,
Ermitteln zumindest eines Test-HF-Sendepulses, wobei der zumindest eine Test-HF-Sendepuls anhand des zumindest einen initialen Sequenzparameters an eine vorgegebene Standardform angepasst ist,
Ermitteln des zumindest einen Betriebsparameters mit Hilfe des zumindest einen Test-HF-Sendepulses.

2. Verfahren nach Anspruch 1,
wobei die vorgegebene Standardform eine Rechteckform ist.

3. Verfahren nach Anspruch 2,
wobei der zumindest eine initiale Sequenzparameter eine, insbesondere maximale, Pulsdauer umfasst, die einer, insbesondere maximalen, Breite der Rechteckform entspricht.

4. Verfahren nach einem der Ansprüche 2 oder 3,
wobei der zumindest eine initiale Sequenzparameter eine, insbesondere maximale, Amplitude umfasst, die einer, insbesondere maximalen, Höhe der Rechteckform entspricht.

5. Verfahren nach einem der vorangehenden Ansprüche,
wobei der zumindest eine Betriebsparameter eine Leistungsanforderung bei Ausführung der Magnetresonanzsequenz an eine Magnetresonanzvorrichtung, insbesondere an einen Hochfrequenzverstärker der Magnetresonanzvorrichtung, umfasst.

6. Verfahren nach einem der vorangehenden Ansprüche,
wobei der zumindest eine Betriebsparameter eine spezifische Absorptionsrate umfasst, die bei Ausführung der Magnetresonanzsequenz auf einen Patienten einwirkt.

7. Verfahren nach einem der vorangehenden Ansprüche,
wobei das Verfahren ferner umfasst:
Bereitstellen zumindest einer Randbedingung an den zumindest einen Betriebsparameter,
Ermitteln zumindest eines angepassten Sequenzparameters durch Anpassung des zumindest einen initialen Sequenzparameters, so dass die bereitgestellte zumindest eine Randbedingung eingehalten wird.

8. Verfahren nach Anspruch 7,
wobei das Verfahren ferner umfasst:
Ermitteln zumindest eines Mess-HF-Sendepulses anhand des zumindest einen angepassten Sequenzparameters.

9. Verfahren nach Anspruch 8,
wobei der zumindest eine Mess-HF-Sendepuls ein dynamischer Puls ist.

10. Verfahren nach einem der Ansprüche 8 oder 9,
wobei der zumindest eine Mess-HF-Sendepuls ein pTx-Puls ist.

11. Verfahren nach einem der Ansprüche 7 bis 10,
wobei der zumindest eine angepasste Sequenzparameter zumindest eine Randbedingung zur Ermittlung des zumindest einen Mess-HF-Sendepulses umfasst.

12. Verfahren nach Anspruch 11,
wobei die zumindest eine Randbedingung zur Ermittlung des zumindest einen Mess-HF-Sendepulses eine maximale Pulsdauer umfasst.

13. Verfahren nach einem der Ansprüche 11 oder 12,
wobei die zumindest eine Randbedingung zur Ermittlung des zumindest einen Mess-HF-Sendepulses eine maximale Amplitude umfasst.

14. Magnetresonanzvorrichtung, die ausgebildet ist, ein Verfahren nach einem der vorangehenden Ansprüche auszuführen.

15. Computerprogrammprodukt, welches ein Programm umfasst und direkt in einen Speicher einer programmierbaren Systemsteuereinheit einer Magnetresonanzvorrichtung ladbar ist, mit Programmmitteln, um ein Verfahren nach einem der Ansprüche 1 bis 13 auszuführen, wenn das Programm in der Systemsteuereinheit der Magnetresonanzvorrichtung ausgeführt wird.
